# EUROPEAN PATENT APPLICATION

(11) **EP 1 961 843 A2**
(43) Date of publication of application: **27.08.2008**
(21) Application number: 08250604.9
(22) Date of filing: 21.02.2008
(51) Int. Cl.: C30B 29/12, C30B 33/02, C30B 15/00

(54) **Method for producing BaLiF3 single crystal**

(30) Priority: 22.02.2007 JP 2007041771
(71) Applicant: Tokuyama Corporation, Shunan-shi, Yamaguchi 745-8648 (JP)
(72) Inventor: Mabuchi, Toshiro c/o Tokuyama Corporation, Yamaguchi 7458648 (JP); Mochizuki, Naoto c/o Tokuyama Corporation, Yamaguchi 7458648 (JP)
(74) Representative: Matthews, Derek Peter

(57) **Abstract**

Disclosed is a method for producing a BaLiF₃ single crystal by a melt growth method, wherein a raw material melt for said single crystal comprising BaF₂, LiF and MgF₂ in such amounts that the Ba/(Ba+Li+Mg) ratio by mol is in the range of 0.35 to 0.48 and the Mg/(Li+Mg) ratio by mol is in the range of 0.001 to 0.03. In the case where a BaLiF₃ single crystal that is useful as a last lens of immersion exposure tools for producing a semiconductor is produced by a melt growth method using, as a raw material, a melt containing excess Li, the Li component is liable to be precipitated to make the resulting BaLiF₃ single crystal opaque, and the light transmittance is deteriorated, but such problems can be solved by the present invention.

## Description

### FIELD OF THE INVENTION

The present invention relates to a method for producing a BaLiF₃ single crystal. More particularly, the invention relates to a method for producing a BaLiF₃ single crystal which is promising as a last lens of immersion exposure tools and has excellent transmission property in the vacuum ultraviolet region of not more than 200 nm.

### BACKGROUND OF THE INVENTION

In a lithographic process that is carried out in a field of production of electronic materials such as semiconductor integrated circuits, a requirement of extremely fining a pattern transferred to a substrate for exposure has been increased, and in order to meet the requirement, enhancement of resolution of an exposure apparatus has been studied.

It is generally known that as the wavelength of light for exposure is shortened and as the numerical aperture of a lens is increased in the exposure apparatus, the resolution line width can.be decreased to enhance the resolution. On this account, together with an attempt to use light of vacuum ultraviolet region having a wavelength of not more than 200 nm (e.g., ArF excimer laser, oscillation wavelength: 193 nm; F₂ excimer laser, oscillation wavelength: 157 nm) as a light source, designing of an optical system capable of coping with light of such a short wavelength, development of lens materials, etc. have been promoted.

In parallel with such attempts, there have been also promoted studies of immersion exposure tools wherein a liquid is filled between a substrate for exposure and a last lens of the exposure apparatus to substantially shorten the wavelength of light on the surface of the substrate for exposure and thereby enhance resolution.

The immersion exposure tool is an apparatus equipped with at least a light source, an illumination optical system, a mask (reticle), a projection optical system and a liquid supply/recovery device, and is an apparatus to carry out light exposure in a state where a liquid is filled between the lens (last lens) installed at the tip of the projection optical system on the side of the substrate for exposure and the substrate for exposure that has a resist film. For the last lens of such immersion exposure tools, various properties such that refractive index and transmittance at a wavelength of light of the light source are high, intrinsic birefringence and stress birefringence are low or do not exist, the lens has resistance to light of the light source, and the lens has resistance to the liquid used are required.

The present inventors have studied materials which have the above properties and are employable as last lenses of the immersion exposure tools. As a result, the present inventors have found that a BaLiF₃ single crystal has excellent properties, and they have already proposed it (see patent document 1).

Further, as a use other than the use as the last lens of the immersion exposure tools, it has been already proposed to use the BaLiF₃ single crystal as an optical member of an apparatus for vacuum ultraviolet light such as an exposure apparatus (e.g., patent documents 2 and 3).

As disclosed in these patent documents 1 and 2, the BaLiF₃ single crystal cannot be produced directly from a melt containing BaF₂ and LiF in a molar ratio of 0.50:0.50 by a melt growth method such as Czochralski method or Bridgman method, and it is necessary to prepare a melt containing excess LiF and to produce the BaLiF₃ single crystal from the melt.

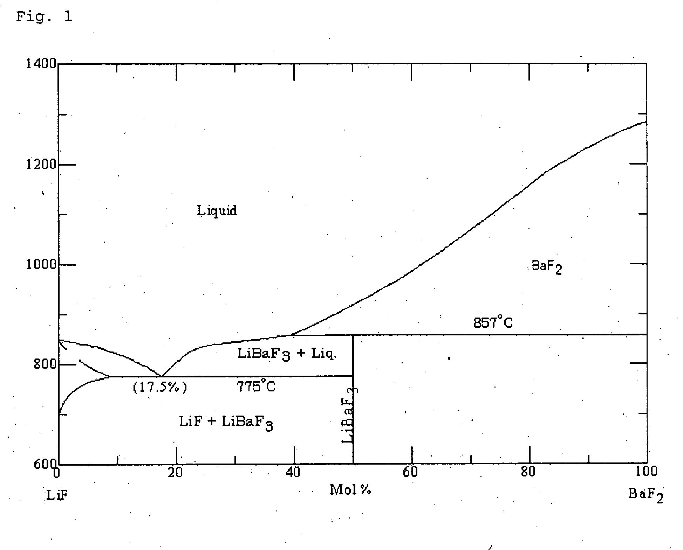

The reason can be understood from a view of phase diagram of the BaF₂ - LiF system shown in Fig. 1. That is to say, as shown in Fig. 1, even if a melt having composition of a BaF₂:LiF molar ratio of 0.50:0.50 is cooled, BaF₂ is precipitated, in the case of this molar ratio, at a temperature higher by about 50 to 60°C than 857°C that is the upper limit of temperatures at which a BaLiF₃ crystal can exist. On that account, it is necessary to prepare a raw material melt having a higher proportion of LiF than 0.50:0.50 that is a stoichiometric composition of a BaLiF₃ single crystal and to bring a seed crystal composed of a BaLiF₃ crystal into contact with the resulting melt to grow a BaLiF₃ single crystal. In other words, a method for directly producing a BaLiF₃ single crystal from molten raw materials having a BaF₂:LiF molar ratio of 0.50:0.50 has not been found yet, and therefore, a melt containing excess LiF is inevitably used.

On the other hand, as an optics for vacuum ultraviolet region, technique of doping a LiCaAlF₆ single crystal with Mg is known. The doping with Mg is carried out in order to inhibit color center that is caused by irradiation with high-energy rays (see, for example, patent document 4).

In a non-patent document 1, a LiBaF₃ crystal containing Mg is disclosed and light emission properties of the crystal are described, but production method(or process) and light transmission property of the crystal are not clear.

Patent document 1: Japanese Patent Laid-Open Publication No. 005777/2007

Patent document 2: Japanese Patent Laid-Open Publication No. 228802/2002

Patent document 3: Japanese Patent Laid-Open Publication No. 119096/2003

Patent document 4: Japanese Patent Laid-Open Publication No. 171197/2003

Non-patent document 1: Journal of Luminescence, 87-89 (2000), 561-563

### OBJECT OF THE INVENTION

However, it has become apparent from the studies by the present inventors that if a BaLiF₃ single crystal is produced from a raw material melt containing an excess of LiF over the stoichiometric composition as above, the resulting crystal looks opaque frequently. This opaqueness tends to occur more intensely at the central part than in the peripheral part of the single crystal and is conspicuous especially when a large-sized single crystal having a straight barrel part of a large diameter is produced. Such opaqueness consequently lowers light transmittance, and therefore, when the BaLiF₃ single crystal is used as an optical material as previously described, the opaqueness becomes a very serious problem.

Although the cause of the opaqueness is presumably that LiF undergoes phase separation and precipitation in the BaLiF₃ single crystal, it has not been completely clarified yet.

Accordingly, it is an object of the present invention to solve the above problem and to efficiently produce a BaLiF₃ single crystal which has excellent light transmission property and is employable as an optics for vacuum ultraviolet region, such as a last lens of immersion exposure tools.

### SUMMARY OF THE INVENTION

The present inventors have earnestly studied in order to solve the above problem, and as a result, they have found that when a single crystal is produced from a raw material melt containing a small amount of MgF₂, occurrence of opaqueness of the crystal can be remarkably decreased even if LiF is added in excess and that a single crystal greatly improved in light transmittance can be stably obtained even if it is a large-sized single crystal. The present inventors have further studied, and as a result, they have accomplished the present invention.

That is to say, the present invention is a method for producing a BaLiF₃ single crystal by a melt growth method, wherein a raw material melt for said single crystal comprises BaF₂, LiF and MgF₂ in such amounts that the Ba/(Ba+Li+Mg) ratio by mol is in the range of 0.35 to 0.48 and the Mg/(Li+Mg) ratio by mol is in the range of 0.001 to 0.03.

### BRIEF DESCRIPTION OF THE DRAWINGS

Fig. 1 is a view of phase equilibrium between LiF and BaF₂. (original source: A.I. Agulyanskii and V.A. Bessonova, Zh. Neorg. Khim., 27 [4] 1029-1032 (1982); Russ. J. Inorg. Chem. (Engl. Transl.), 27 [4] 579-581 (1982))
Fig. 2 is a schematic view of a CZ furnace having a double structure crucible.used in the examples (view showing a state of pulling a crystal).
Fig. 3 shows results of measurements of VUV transmittances of BaLiF₃ single crystals produced from melts prepared so as to have a Mg/(Li+Mg) ratio of 0.01.
Fig. 4 shows results of measurements of VUV transmittances of BaLiF₃ single crystals produced from melts prepared so as to have a Mg/(Li+Mg) ratio of 0.005.
Fig. 5 shows results of measurements of VUV transmittances of BaLiF₃ single crystals produced without adding Mg.
Fig. 6 shows results of measurements of X-ray induced absorption.
Fig. 7 shows VUV transmittances of a test specimen before annealing.
Fig. 8 shows VUV transmittances of a test specimen after annealing.
Fig. 9 is a view showing appearance (before annealing) of a BaLiF₃ single crystal containing Mg.
Fig. 10 is a view showing a structure of an annealing furnace.
Fig. 11 is a view showing appearance (after annealing) of a BaLiF₃ single crystal containing Mg.
Fig. 12 is a view showing appearance (before annealing) of a BaLiF₃ single crystal containing no Mg.
Fig. 13 is a view showing appearance (after annealing) of a BaLiF₃ single crystal containing no Mg.

### Description of numerals

1: outer crucible
2: inner crucible
3: through hole
4: outer crucible supporting shaft
5: pedestal
6: heater
7: chamber
8: heat insulation material wall
9: insulation wall
10: lid material
11: seed crystal
12: seed crystal holding tool
13: crystal pulling shaft
14: single crystal
15: opening part shielding member
16: hook
17: inner crucible hanging rod
18: connecting member
19: melt
101: BaLiF₃ single crystal
102: cylindrical container
103: heater
104: heat insulation material
105: rotating shaft
106: chamber

### DETAILED DESCRIPTION OF THE INVENTION

The production method of the invention is a method for producing a single crystal by a so-called melt growth method wherein a seed crystal is brought into contact with a raw material melt to gradually crystallize the melt from a portion that is in contact with the seed crystal, whereby a single crystal is grown in agreement with the crystal orientation of the seed crystal.

Examples of the melt growth methods include Czochralski method and Bridgman method, and any of these methods may be applied to the production method of the invention. From the viewpoint of ease of production in the case where the composition of the raw materials is different from that of the single crystal to be produced, the Czochralski method is preferably applied to the production of a BaLiF₃ single crystal of the invention.

Preparation of the raw material melt is usually carried out by mixing BaF₂, LiF and MgF₂ in given proportions and melting them under heating. As BaF₂, LiF and MgF₂, those containing as small amounts of impurities as possible are preferably used, and the concentration of metallic impurities other than alkaline earth metals is desired to be not more than 10 ppm by weight, preferably not more than 5 ppm by weight, particularly preferably not more than 1 ppm by weight. Further, it is preferable to use raw materials from which water and oxides (BaO, Li₂O, MgO, etc.) have been removed as much as possible.

A seed crystal composed of a BaLiF₃ single crystal is brought into contact with a raw material melt prepared by mixing the raw materials BaF₂, LiF and MgF₂ in such amounts that the Ba/(Ba+Li+Mg) ratio by mol, namely, number of Ba atoms/(total of number of Ba atoms, number of Li atoms and number of Mg atoms), becomes 0.35 to 0.48 and the Mg/(Li+Mg) ratio by mol, namely, number of Mg atoms/(total of number of Li atoms and number of Mg atoms), becomes 0.001 to 0.03, and the seed crystal is slowly pulled up to obtain a crystal. In the melt growth method, a BaLiF₃ single crystal having a size that is employable as,an optical material, particularly a lens of an exposure apparatus, cannot be actually obtained with reproducibility unless raw materials having an excess of Li over Ba are used, as previously described. In the following description, the ratios of the components of Ba, Li and Mg are on the basis of mol unless otherwise noted.

The greatest feature of the present invention is to use a melt containing Mg of the above range as a raw material melt. If Mg is not added to the raw material melt, the crystal markedly becomes opaque in many cases, and even if Mg is added, its effect is hardly obtained when the amount of Mg added is such an amount that the Mg/(Li+Mg) ratio is less than 0.001.

On the other hand, if the amount of Mg added is too large, not only the effect reaches the uppermost limit but also there occurs a problem such that a heterogeneous crystal containing Mg as a constituent is precipitated in a large amount in the BaLiF₃ single crystal, and in an extreme case, the whole crystal obtained becomes an entirely different crystal. Moreover, the amount of Mg incorporated into the resulting BaLiF₃ single crystal becomes large, and induced absorption in the vicinity of 200 to 600 nm due to irradiation with high-energy rays tends to increase, as described later.

As described above, Mg is added in such an amount that the Mg/(Li+Mg) ratio is in the range of 0.001 to 0.03, more preferably 0.002 to 0.02, particularly preferably 0.003 to 0.015.

In the crystal growth, the raw materials BaF₂, LiF and MgF₂ having been mixed in the aforesaid molar ratio are filled in a crucible made from carbon such as a high-density graphite sintered body, a platinum crucible or the like and heated in a furnace to a temperature of not lower than the melting temperature. The melting temperature varies depending upon the molar ratio between BaF₂ and LiF, as shown' in Fig. 1. Although the melting temperature is slightly changed also by the addition of MgF₂, the amount of MgF₂ added is small, and therefore, there is substantially no trouble even if the melting temperature of the mixture of BaF₂, LiF and MgF₂ is regarded as a temperature at which the mixture of BaF₂ and LiF shown in Fig. 1 is completely melted, i.e., liquidus'temperature. In order to sufficiently melt the mixture, the highest temperature in the heating is usually set at about a temperature of the melting temperature + (10 to 200)°C. More specifically, when the Ba/(Ba+Li+Mg)-ratio is 0.35, the highest temperature is set at about 860 to 1050°C, and when the Ba/(Ba+Li+Mg) ratio is 0.48, the highest temperature is set at about 920 to 1110°C

As the raw materials to be filled in the crucible, those in the form of powders or lumps may be used, or a sintered body or a solidified body obtained by mixing the raw materials in a given ratio and then heating the mixture may be used. Prior to melting in the furnace, the furnace is also preferably evacuated (preferably about 10⁻⁵ to 10⁻² Pa) until the temperature becomes about 600 to 650°C, from the viewpoint that volatile impurities such as adsorbed water can be removed. Further, it is also preferable to introduce a fluorine-based gas such as HF or CF₄ after evacuation or without evacuation and to heat the raw materials in an atmosphere of the fluorine-based gas, from the viewpoint that water and oxides can be efficiently removed.

Such a method to grow a crystal from a raw material melt as above has only to be carried out in accordance with a melt growth method publicly known, such as Czochralski method (CZ method) or Bridgman method. Hereinafter, a method to grow a BaLiF₃ crystal using the CZ method is described more specifically.

In the case where the BaLiF₃ single crystal is grown by the CZ method, a seed crystal composed of a BaLiF₃ single crystal is brought into contact with a raw material melt having been sufficiently melted, and the seed crystal is slowly pulled up. The seed crystal can be arbitrarily selected in accordance with the orientation of the crystal to be pulled up. For example, a crystal of <100> or <111> can be used.

As the crucible, a double structure crucible consisting of an inner crucible and an outer crucible disclosed in Japanese Patent Laid-Open Publication No. 199577/2006 or the like is also preferably used.

The double structure crucible consists of an outer crucible and an inner crucible placed in the outer crucible. Internal spaces of the outer crucible and the inner crucible in the double structure crucible partially open into each other, and the depth of the inner crucible placed in the outer crucible can be continuously changed. In usual, the position of the inner crucible is fixed, and by vertically moving the outer crucible, the depth of the inner crucible against the outer crucible is changed. Such a double structure crucible is placed in a chamber for constituting a Czochralski furnace (CZ furnace), and just above the internal space of the inner crucible in the chamber, a single crystal pulling rod equipped with a seed crystal at its tip and capable of vertical motion is installed.

Pulling can be carried out at atmospheric pressure, under reduced pressure or under pressure. From the viewpoint that a BaLiF₃ single crystal having few crystal defects such as negative crystal is easily obtained, pulling is preferably carried out under reduced pressure. When pulling is carried out under reduced pressure, the furnace pressure is in the range of usually 0.5 to 70 kPa, preferably 1 to 50 kPa, more preferably 1 to 30 kPa. The pulling can be carried out in an atmosphere of a fluorine-based gas such as HF or CF₄, an inert gas such as Ar, He, Ne or N₂, a fluorine-based gas having been diluted with the inert gas, or the like. The pulling is preferably carried out in an atmosphere of a fluorine-based gas or a fluorine-based gas having been diluted with an inert gas, from the viewpoint that influences of oxygen are easily removed. The pulling rate is in the range of usually 0.1 to 20 mm/hr.

After the BaLiF₃ crystal having a desired length is pulled up, it is cooled to about room temperature and taken out of the CZ furnace. In the cooling, as the cooling rate is increased, occurrence of phase separation is decreased, but on the other hand, if the cooling rate is extremely high, there sometimes occurs a problem that the crystal produced (pulled up) is cracked by thermal shock. Therefore, the cooling rate is in the range of preferably 1 to 500°C/hr, more preferably 3 to 50°C/hr.

When the BaLiF₃ single crystal is produced from the raw material melt containing a given amount of Mg in the above manner, opaqueness that is presumed to be a precipitate of LiF less occurs than the case of production without adding Mg, and thereby a crystal having excellent light transmission property is obtained in an extremely high proportion. In many cases, a BaLiF₃ single crystal having an internal transmittance at a wavelength of 193 nm of not less than 90% is obtained, and a single crystal having an internal transmittance of not less than 97%, particularly not less than 98%, can be also obtained.

In the BaLiF₃ single crystal produced as above, a small amount of Mg is usually contained. The amount of Mg in the BaLiF₃ single crystal tends to become smaller than the proportion of Mg to Li in the raw material melt. Further, in comparison of the first half and the latter half of the crystal growth, the amount of Mg contained tends to be larger in the later half. The reason for this is presumably that Mg that is an impurity to the BaLiF₃ single crystal is hardly incorporated and the Mg concentration in the raw material melt is gradually increased with growth of the crystal. Such a phenomenon of segregation of Mg is conspicuously observed particularly in the case where the proportion of Mg contained in the raw material melt is high. On the other hand, as the proportion of Mg contained in the raw material melt is decreased, the ratio of Mg to Li+Mg in the resulting BaLiF₃ single crystal tends to approach the composition of the raw material melt. When the Mg/(Li+Mg) ratio is less than 0.002, the proportion of Mg in the BaLiF₃ single crystal and the proportion of Mg in the raw material melt generally tend to agree with each other.

According to the studies by the present inventors, in the BaLiF₃ single crystal produced by the production method of the invention, Mg is contained in a Mg/(Li+Mg) ratio of usually 0.001 to 0.02. If the Mg content is increased, induced absorption due to irradiation with high-energy rays is increased, and in the case where the resulting crystal is used as, for example, a lens or a window material for lithography for a long period of time, there is-a possibility of lowering of laser resistance. On this account, if the resulting crystal is used for such a purpose, the crystal preferably contains Mg in a Mg/(Li+Mg) ratio of 0.001 to 0.01.

A BaLiF₃ single crystal having a low Mg content can be obtained by decreasing the amount of MgF₂ within the aforesaid range in the production of the crystal or by cutting out a crystal from the upper part of an ingot produced by the CZ method (or from the lower part in the case of the Bridgman method).

As a matter of course, a BaLiF₃ single crystal having a high Mg content can be also used if induced absorption due to irradiation with high-energy rays is no consideration.

Since the BaLiF₃ single crystal obtained by the production method of the invention has an excellent vacuum ultraviolet light transmittance, it can be preferably used as a window material, an illumination lens or a projection lens of a lithographic apparatus and is particularly useful as a last lens of immersion exposure tools. In the case where the BaLiF₃ single crystal is used as the last lens, the BaLiF₃ single crystal is preferably subjected to annealing to remove strain after it is produced by the melt growth method such as Czochralski method or Bridgman method, because the as-grown BaLiF₃ single crystal has large residual strain, and sufficient resolution cannot be obtained occasionally.

To the annealing, a method publicly known as a method of annealing fluoride single crystals has only to be applied. More specifically, the BaLiF₃ single crystal is heated up to a temperature that is lower than the melting point (857°C) of BaLiF₃ by usually about 5 to 100°C, preferably about 5 to 50°C, and then slowly cooled. The cooling rate is in the range of about 0.1 to 5°C/hr, particularly about 0.1 to 2°C/hr. It is also effective that lowering of temperature is carried out slowly in the high-temperature region and that the cooing rate is gradually increased as the temperature is lowered.

In the case of a BaLiF₃ single crystal containing no Mg, opaqueness is frequently increased in the usual annealing though the reason is not clear, and therefore, it is difficult to obtain a BaLiF₃ single crystal having transparency and small strain, particularly a large-sized single crystal. In the case of the BaLiF₃ single crystal of the invention produced by the production method of the invention, however, annealing makes it possible to further decrease opaqueness of the BaLiF₃ single crystal.

That is to say, by introducing Mg into the raw material melt in the aforesaid given amount, opaqueness occurring in the crystal can be greatly decreased as compared with a BaLiF₃ single crystal produced from a raw material melt containing no Mg, even if annealing is not performed. However, when the single crystal produced is a large-sized one, that is, when the straight barrel part diameter is large, a little opaqueness still occurs occasionally in the vicinity of the central part. On this account, in the case of a large-sized single crystal, transmittance at the central part sometimes becomes lower than that in the peripheral part. If the single crystal having such opaqueness is subjected to annealing, opaqueness is further decreased, and a difference in transmittance between the central part and the peripheral part can be reduced, so that the transmittance can be further improved as a whole.

Although the reason of occurrence of such a phenomenon is not clear, it is presumed that introduction of Mg into the BaLiF₃ single crystal has influence.

Although the annealing may be carried out while the BaLiF₃ single crystal is in the form of an ingot, it is more effective to carry out annealing after the ingot is processed to a size close to the final part shape.

The BaLiF₃ single crystal from which strain has been removed to a necessary extent by the annealing is further processed into a shape of the final part and then used.

The BaLiF₃ single crystal obtained by the production method of the invention can be used as a lens, a lens blank, a prism, an optical window or the like of an exposure apparatus. In particular, the BaLiF₃ single crystal is useful as a lens, such as a last lens of immersion exposure tools, or a lens blank that is a raw material for producing the lens.

According to the production method of the invention, it becomes easy to produce a large-sized-lens blank having a diameter of 40 to 300 mm (particularly 80 to 200 mm) and a thickness of 30 to 200 mm (particularly 50 to 150 mm) and having an internal transmittance at a wavelength of 193 nm of more than 90%, though it has been difficult in the past to stably produce such a lens blank.

### EFFECT OF THE INVENTION

According to the above production method, a BaLiF₃ single crystal having excellent light transmittance can be efficiently produced. Further, a BaLiF₃ single crystal having, excellent light transmission property can be efficiently produced even if it is a large-sized one. Furthermore, since the amount of Mg is small, the resulting BaLiF₃ single crystal is rarely impaired in properties inherent in a BaLiF₃ single crystal, and the BaLiF₃ single crystal is extremely useful as a last lens of immersion exposure tools or the like.

### EXAMPLES

The present invention is further described with reference to the following examples, but,it should be construed that the invention is in no way limited to those examples.

### Raw materials

As the MgF₂, BaF₂ and LiF raw materials, those in which Ti, Cr, Mn, Fe, Co, Ni, Cu, Cd, Pb, Zn, Y, La, Ce, Eu and Yb contents were each less than 1 ppm by weight in terms of a concentration of a metal as an impurity were used.

### ICP emission spectral analysis

Emission spectral analysis of an ingot was carried out in the following manner. A disc obtained from the ingot was crushed, weighed into a Teflon beaker, then thermally decomposed with perchloric acid and nitric acid, and dissolved in dilute nitric acid under heating, followed by making the volume constant.

The resulting solution was subjected to ICP emission spectral analysis to obtain Mg content, Li content and Ba content in the sample, and the contents were converted to a compositional ratio (molar ratio). The same disc was subjected to the analysis twice, and the mean value was taken as the analysis value. Further, the results were processed with two significant figures.

The same sample was subjected to X-ray fluorescence analysis (XRF) to measure Mg content and Ba content in the sample, and calculation was made on the assumption that Li, Mg and Ba were contained in a (Li+Mg):Ba ratio of 50:50, to determine Li, Mg and Ba contents. The resulting Li, Mg and Ba contents also agreed with the results of the ICP emission spectral analysis.

### X-ray induced absorption

Front and back surfaces of a disc obtained from an ingot were optically polished to give a test specimen having a thickness of 2 mm, and a vis-UV spectrum of the specimen was measured. Thereafter, the test specimen was irradiated with X rays for 10 minutes using an X-ray fluorescence analytical device. As the irradiation conditions, Cu-Kα ray was used, and the vessel current/voltage was 25 kV/180 mA. After irradiation with X-rays, a vis-UV spectrum was measured again, and from a ratio of spectral intensity between before and after the irradiation with X-rays, quantity of light absorption induced by irradiation with X rays (X-ray induced absorption) was determined.

### Evaluation of ingot

The resulting ingot was irradiated with light of a halogen lamp in a dark room to observe opaqueness with the naked eye. An ingot having high transparency inside and having no scattering point was judged to have opaqueness "AA", and an ingot having low transparency and having a scattering point was judged to have opaqueness "CC".

Further, crystal appearance of the ingot was visually observed. An ingot in which precipitation of a heterogeneous phase was not found was judged to have crystal appearance "good", and an ingot in which precipitation of a heterogeneous phase was found was judged to have crystal appearance "heterogeneous phase precipitation".

### Example 1

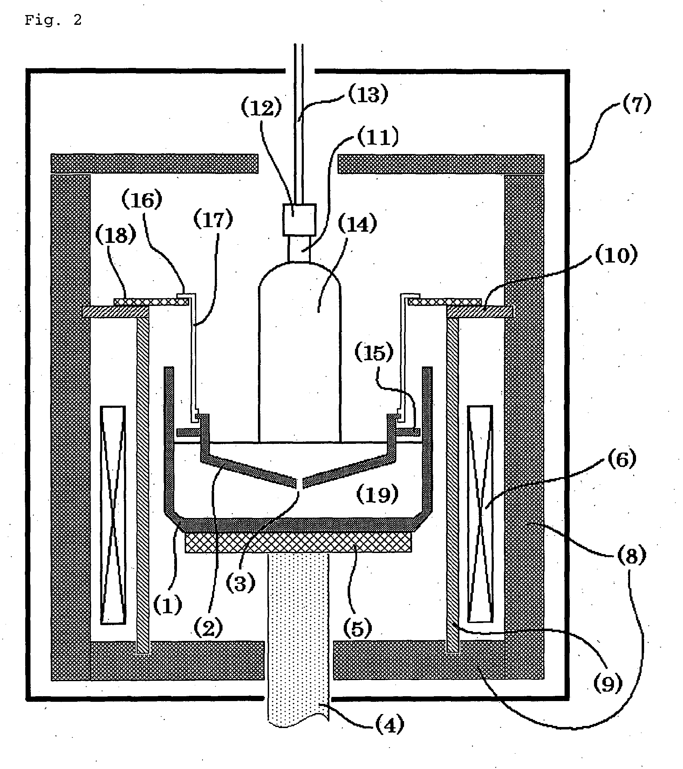

8351 g of a lump of a BaF₂ raw material, 1622 g of a lump of a LiF raw material and 39 g of a MgF₂ powder were mixed and introduced into a double structure crucible consisting of an inner crucible and an outer crucible disclosed in Japanese Patent Laid-Open Publication No. 199577/2006, and the double structure crucible was placed'in a CZ furnace. The BaF₂ raw material, the LiF raw material and the MgF₂ raw material were mixed herein in a Ba/(Ba+Li+Mg) mixing ratio by mol of 0.43 and a Mg/(Li+Mg) mixing ratio by mol of 0.01. The inner diameter of the outer crucible to constitute the double structure crucible was 225 mm, and the inner diameter of the inner crucible was 180 mm. In Fig. 2, a schematic view of the CZ furnace used is shown.

Next, the crucible was heated up to 600°C over a period of 24 hours with maintaining the degree of vacuum in the furnace at not more than 1×10⁻³ Pa, and then a CF₄ gas having a purity of 99.999% was introduced into the furnace to adjust the furnace pressure to atmospheric pressure. Thereafter; the crucible was heated up to 900°C over a period of 2 hours to melt the mixture.

Next, the furnace was gradually evacuated with an oil rotary pump to remove the furnace gas and to adjust the furnace pressure to 10 kPa, and then the temperature was lowered until the temperature of the melt became a crystallization temperature of a BaLiF₃ single crystal.

Next, a seed crystal composed of a BaLiF₃ single crystal whose pulling direction was <100> was brought into contact with the raw material melt in the crucible, and the seed crystal was pulled up at a rate of 1.0 mm/hr with rotating the seed crystal at 10 rpm, to grow an ingot of the BaLiF₃ single crystal. After the ingot of the BaLiF₃ single crystal was grown to a given size, the ingot was cut off from the melt.

Next, the CZ furnace was cooled over a period of 100 hours, and then the ingot was taken out of the CZ furnace. The resulting ingot had an overall length of 140 mm, a straight barrel part length of 100 mm and a strait barrel part diameter of 75 mm.

The ingot was irradiated with light of a halogen lamp in a dark room and observed with the naked eye. As a result, transparency inside the ingot was high, and no scattering point was confirmed.

Next, the ingot was cut on the {100} face vertical to the growing direction to obtain three discs, and the front and back surfaces of the discs were optically polished to prepare test specimens having a thickness of 10 mm.

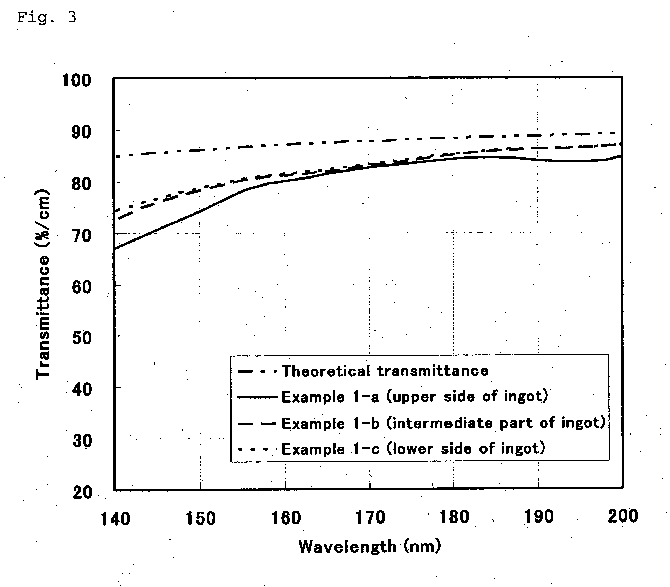

Next, the three test specimens were measured on the vacuum ultraviolet light (VUV) transmittance. The results are shown in Fig. 3. The mean value of the VUV transmittances at a wavelength of 193 nm was 85.5% (minimum value: 83.7%, maximum value: 86.5%). The theoretical transmittance of a BaLIF₃ single crystal at a wavelength of 193 nm is 88.9% (refractive index: 1.64), and therefore, the mean value of the internal transmittances of the evaluated BaLiF₃ single crystal discs except surface reflection was 96.2% (minimum value: 94.2%, maximum value: 97.3%).

Next, of the three BaLiF₃ single crystal discs, two discs corresponding to the upper side and the lower side of the ingot were evaluated on the Mg content by the ICP emission spectral analysis. As for the Mg content, the sample obtained from the disc of the upper side had a Mg/(Li+Mg) ratio of 0.0030, and the sample obtained from the disc of the lower side had a Mg/(Li+Mg) ratio of 0.0043.

### Example 2

An ingot of a BaLiF₃ single crystal was obtained in the same manner as in Example 1, except that 8350 g of a lump of a BaF₂ raw material, 1630 g of a lump of a LiF raw material and 20 g of a MgF₂ powdery raw material were mixed and introduced into a double structure crucible, and the crucible was placed in a CZ furnace. The BaF₂ raw material, the LiF raw material and the MgF₂ raw material were mixed herein in a Ba/(Ba+Li+Mg) mixing ratio by mol of 0.43 and a Mg/(Li+Mg) mixing ratio by mol of 0.005.

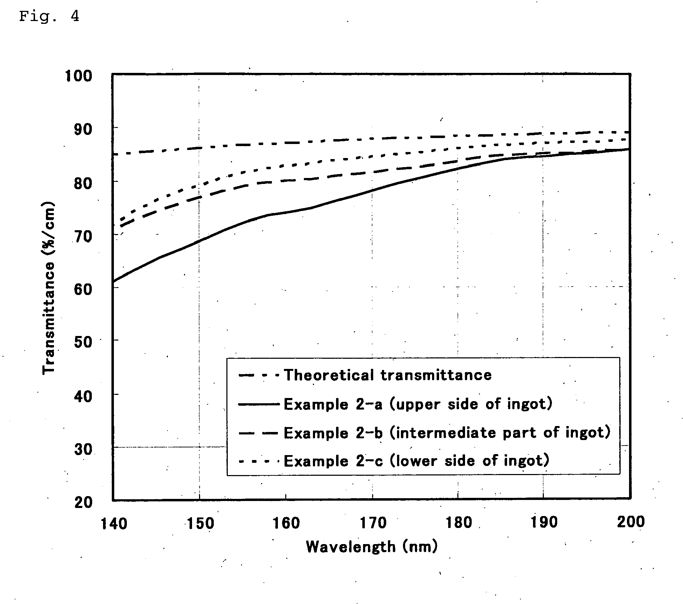

Next, the ingot was cut in the same manner as in Example 1 to obtain three discs, and then these discs were measured on the VUV transmittance. The results are shown in Fig. 4. The mean value of the VUV transmittances at a wavelength of 193 nm was 85.8% (minimum value: 85.3%, maximum value: 87.3%), and the mean value of the internal transmittances except surface reflection was 96.5% (minimum value: 96.0%, maximum value: 98.2%).

Next, of the three BaLiF₃ single crystal discs, two discs corresponding to the upper side and the lower side of the ingot were evaluated on the Mg content by the ICP emission spectral analysis. As for the Mg content, the sample obtained from the disc of the upper side had a Mg/(Li+Mg) ratio of 0.0021, and the sample obtained from the disc of the lower side had a Mg/(Li+Mg) ratio of 0.0028.

### Comparative Example 1

An ingot of a BaLiF₃ single crystal was obtained in the same manner as in Example 1, except that 8360 g of a lump of a BaF₂ raw material and 1640 g of a lump of a LiF raw material were mixed and introduced into a double structure crucible, and the crucible was placed in a CZ furnace. The BaF₂ raw material and the LiF raw material were mixed herein in a Ba/(Ba+Li) mixing ratio by mol of 0.43.

The resulting ingot was irradiated with light of a halogen lamp in a dark room and observed with the naked eye. As a result, it was confirmed that the light was scattered inside the ingot to make the ingot opaque.

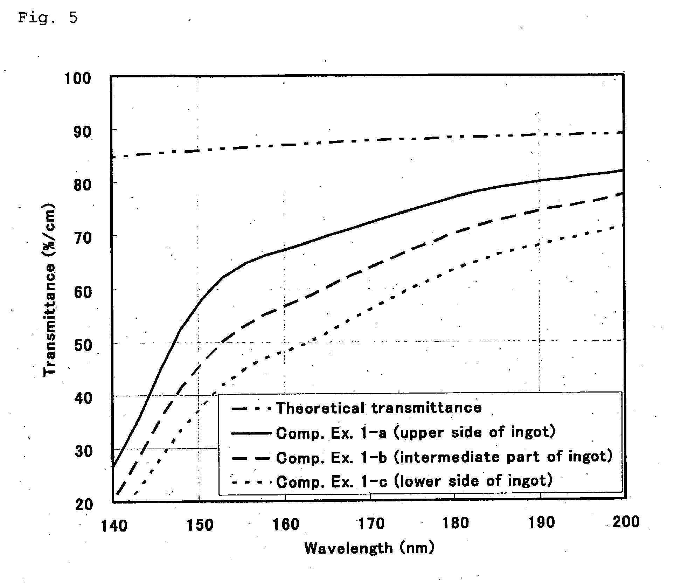

Next, the ingot was cut in the same manner as in Example 1 to obtain three discs, and the discs were measured on the VUV transmittance. The results are shown in Fig. 5. The mean value of the VUV transmittances at a wavelength of 193 nm was 75.1% (minimum value: 69.2%, maximum value: 80.1%), and the mean value of the internal transmittances except surface reflection was 84.5% (minimum value: 77.8%, maximum value: 90.1%).

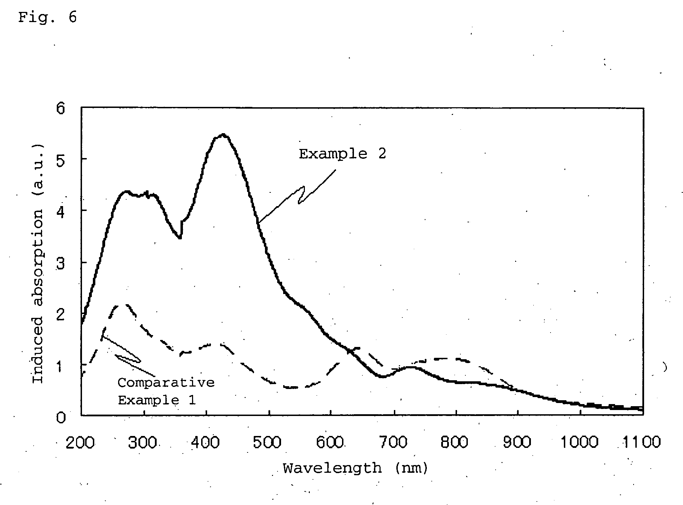

Further, the discs obtained from the vicinities of the intermediate parts of the ingots obtained in Example 2 and Comparative Example 1 were measured on the X-ray induced absorption. The results are shown in Fig. 6.

### Examples 3 to 6

A lump of a BaF₂ raw material, a lump of a LiF raw material and a MgF₂ powder were mixed in mixing ratios by mol (Ba/(Ba+Li+Mg), Mg/(Li+Mg)) shown in Tables 1 to 2 and introduced into.a double structure crucible, and the crucible was placed in a CZ furnace. The inner diameter of the outer crucible to constitute the double structure crucible was 120 mm, and the inner diameter of the inner crucible was 84 mm.

Next, the crucible was heated up to 600°C over a period of 24 hours with maintaining the degree of vacuum in the furnace at not more than 1×10⁻³ Pa, and then a CF₄ gas having a purity of 99.999% was introduced into the furnace to adjust the furnace pressure to atmospheric pressure. Thereafter, the crucible was heated up to 900°C over a period of 2 hours to melt the mixture.

Next, the furnace was cooled until the temperature of the melt became a crystallization temperature of a BaLiF₃ single crystal.

Next, a seed crystal composed of a BaLiF₃ single crystal was brought into contact with the raw material melt in the crucible, and the seed crystal was grown under the growing conditions shown in Tables 1 to 2 to give an ingot of the single crystal. After the ingot of the BaLiF₃ single crystal was grown to a given size, the ingot was cut off from the melt. Then, the CZ furnace was cooled under the conditions shown in Tables 1 to 2, and thereafter, the ingot was taken out of the CZ furnace. The resulting ingot had an overall length of 135 mm, a straight barrel part length of 100 mm and a strait barrel part maximum diameter of 50 mm.

The ingot was irradiated with light of a halogen lamp in a dark room to observe opaqueness and crystal appearance with the naked eye. The results are set forth in Tables 1 to 2.

Next, the ingot was cut on the face vertical to the growing direction to obtain three discs, and the front and back surfaces of the discs were optically polished to prepare test specimens having a thickness of 10 mm.

Next, the test specimen of the upper side of the ingot was measured on the vacuum ultraviolet light (VUV) transmittance at a wavelength of 193 nm. The results are set forth in Tables 1 to 2.

### Comparative example 2

Experiments were carried out in the same manner as-in Examples 3 to 6, except that the conditions were changed as shown in Tables 1 to 2. The results are set forth in Tables 1 to 2.

**Table 1**

| | Raw material mixing ratio (by mol) | | Growing conditions | | | | |
|---|---|---|---|---|---|---|---|
| | Mg/(Li+Mg) | Ba/(Ba+Li+Mg) | Pulling rate (mm/hr) | Crystal rotation rate (r pm) | Atmosphere | Cooling time(hr) | Growing direction |
| EX. 3 | 0.005 | 0.43 | 1.0 | 15 | CF₄ gas, atmospheric pressure | 36 | <100> |
| Ex. 4 | 0.005 | 0.43 | 1.0 | 15 | CF₄ gas, atmospheric pressure | 36 | <100> |
| Ex. 5 | 0.005 | 0.43 | 1.0 | 15 | CF₄ gas, atmospheric pressure | 36 | <100> |
| Ex. 6 | 0.010 | 0.43 | 1.0 | 15 | CF₄ gas, atmospheric pressure | 36 | <100> |
| Comp. Ex. 2 | 0.000 | 0.43 | 1.0 | 15 | CF₄ gas, atmospheric pressure | 36 | < 111> |

**Table 2**

| | Opaqueness | Mean value of VUV transmittances at 193 nm (%/cm) | Mean value of VUV internal transmittances at 193 nm (%/cm) | Crystal appearance |
|---|---|---|---|---|
| EX. 3 | AA | 84.6 | 95.2 | good |
| Ex. 4 | AA | 83.1 | 93.5 | good |
| Ex. 5 | AA | 82.6 | 92.9 | good |
| Ex. 6 | AA | 83.7 | 94.2 | good |
| Comp. Ex. 2 | CC | 78.9 | 88.8 | good |

### Examples 7 to 10

Experiments were carried out in the same manner as in Examples 3 to 6, except that the same CZ furnace as in Example 1 was used and the conditions were changed as shown in Tables 3 to 4. The resulting ingot had an overall length of 140 mm, a straight barrel part length of 100 mm and a strait barrel part maximum diameter of 75 mm. The results are set forth in Tables 3 to 4.

### Comparative Examples 3 to 5

Experiments were carried out in the same manner as in Examples 3 to 6, except that the same CZ furnace as in Example 1 was used and the conditions were changed as shown in Tables 3 to 4. The resulting ingot had an overall length of 140 mm, a straight barrel part length of 100 mm and a strait barrel part maximum diameter of 75 mm. The results are set forth in Tables 3 to 4.

**Table 3**

| | Raw material mixing ratio (by mol) | | Growing conditions | | | | |
|---|---|---|---|---|---|---|---|
| | Mg/(Li+Mg) | Ba/(Ba+Li+Mg) | Pulling rate (mm/hr) | Crystal rotation rate (r p m) | Atmosphere | Cooling time (hr) | Growing direction |
| EX. 7 | 0.002 | 0.43 | 1.0 | 10 | CF₄ gas, 10 kPa | 84 | <100> |
| EX. 8 | 0.005 | 0.43 | 1.0 | 10 | CF₄ gas, atmospheric pressure | 9 6 | <100> |
| EX. 9 | 0.005 | 0.43 | 1.0 | 10 | CF₄ gas, atmospheric pressure | 1 8 0 | <100> |
| EX. 10 | 0.020 | 0.43 | 1.0 | 10 | CF₄ gas, atmospheric pressure | 9 6 | <100> |
| Comp.Ex. 3 | 0. 000 | 0.43 | 1.0 | 8 | CF₄ gas, 1 0 k P a | 2 7 0 | <100> |
| Comp.Ex. 4 | 0.0005 | 0.43 | 1.0 | 10 | CF₄ gas, atmospheric pressure | 9 6 | <100> |
| Comp. Ex. 5 | 0.050 | 0.43 | 1.0 | 10 | CF₄ gas, atmospheric pressure | 9 6 | <100> |

**Table 4**

| | Opaqueness | Mean value of VUV transmittances at 193 nm (%/cm) | Mean value of VUV internal transmittances at 193 nm (%/cm) | Crystal appearance |
|---|---|---|---|---|
| EX. 7 | AA | 84.4 | 94.9 | good |
| EX. 8 | AA | 80.5 | 90.6 | good |
| EX. 9 | AA | 83.0 | 93.4 | good |
| EX. 10 | AA | 80.7 | 90.8 | good |
| Comp.Ex. 3 | CC | 75.1 | 84.5 | good |
| Comp.Ex. 4 | CC | 75.0 | 84.4 | good |
| Comp. Ex. 5 | AA | 79.7 | 89.7 | heterogeneous phase precipitation |

### Comparative Example 6

A BaLiF₃ single crystal was produced again under the same conditions as in Comparative Example 5. Also in this case, precipitation of a heterogeneous phase was confirmed in the ingot.

### Example 11

20900 g of a lump of a BaF₂ raw material, 4100 g of a lump of a LiF raw material and 49 g of a lump of a MgF₂ raw material were mixed and introduced into a double structure crucible, and the crucible was placed in a CZ furnace. The BaF2 raw material, the LiF raw material and the MgF₂ raw material were mixed herein in a Ba/(Ba+Li+Mg) mixing ratio by mol of 0.43 and a Mg/(Li+Mg) mixing ratio by mol of 0.005. The inner diameter of the outer crucible to constitute the double structure crucible was 260 mm, and the inner diameter of the inner crucible was 225 mm.

Next, the crucible was heated up to 600°C over a period of 24 hours with maintaining the degree of vacuum in the furnace at not more than 1×10⁻³ Pa, and then a CF₄ gas having a purity of 99.999% was introduced into the furnace to adjust the furnace pressure to atmospheric pressure. Thereafter, the crucible was heated up to 900°C over a period of 2 hours to melt the mixture.

Next, the furnace was gradually evacuated with an oil rotary pump to remove the furnace gas and to adjust the furnace pressure to 10 kPa, and then the temperature was lowered until the temperature of the melt became a crystallization temperature of a BaLiF₃ single crystal.

Next, a seed crystal composed of a BaLiF₃ single crystal whose pulling direction was <100> was brought into contact with the raw material melt in the crucible, and the seed crystal was pulled up at a rate of 1.0 mm/hr with rotating the seed crystal at 6 rpm, to grow an ingot of the BaLiF₃ single crystal. After the ingot of the BaLiF₃ single crystal was grown to a given size, the ingot was cut off from the melt.

Next, the CZ furnace was cooled over a period of 130 hours, and then the ingot was taken out of the CZ furnace. The resulting ingot had an overall,length of 120 mm, a straight barrel part length of 45 mm and a strait barrel part maximum diameter of 150 mm.

Next, the ingot was cut on the {100} face vertical to the growing direction to obtain a disc, and the front and back surfaces of the disc were optically polished until the surface roughness (rms) became not more than 3.0 nm, to prepare a test specimen having a thickness of 45 mm.

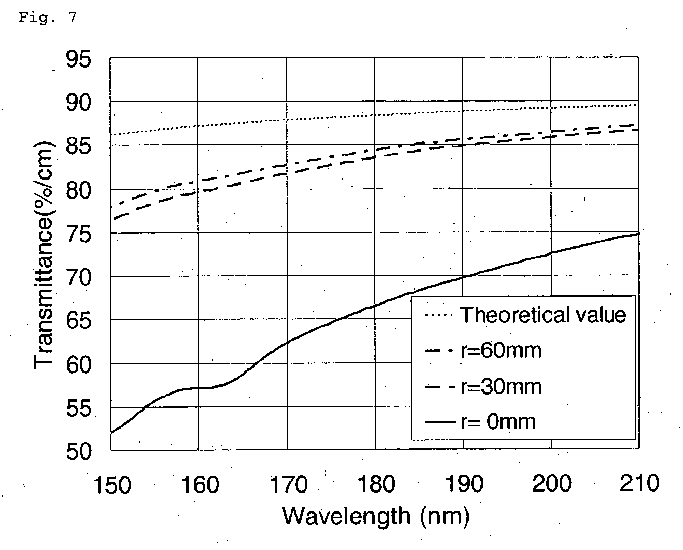

Next, the test specimen was measured on the vacuum ultraviolet light (VUV) transmittance at three points of 0 mm, 30 mm and 60 mm from the center of the test specimen in the radial direction. The results are shown in Fig. 7. The mean value of the VUV transmittances at a wavelength of 193 nm was 80.6%/cm (minimum value: 70.6%/cm, maximum value: 85.9%/cm), and the mean value of the internal transmittances except surface reflection was 90.7%/cm (minimum value: 79.4%/cm, maximum value: 96.6%/cm).

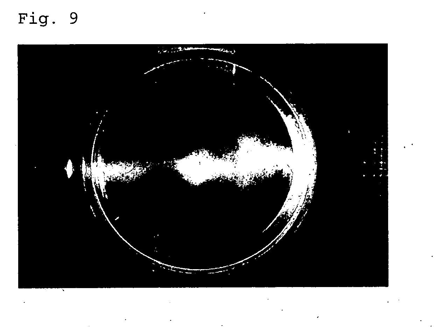

The test specimen was irradiated with light of a halogen lamp in a dark room and observed with the naked eye. As a result, the central part of the ingot was slightly opaque, but in other parts a scattering point was hardly confirmed. A photograph taken when the test specimen was observed using light of a halogen lamp is shown in Fig. 9.

Next, the test specimen was subjected to the following annealing.

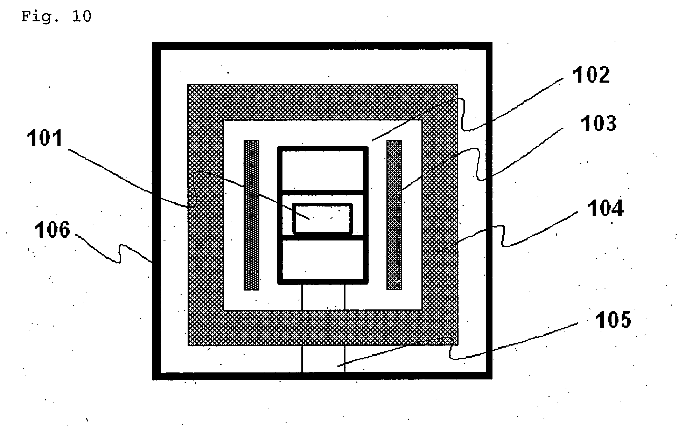

First, the test specimen was placed in a cylindrical container made of a high-density graphite'sintered body, and the cylindrical container was placed in an annealing furnace having a structure whose schematic sectional view is shown in Fig. 10.

With evacuating the furnace (not more than 1×10⁻² Pa) with a diffusion pump and an oil rotary pump, the furnace was heated at a rate of 50°C/hr until the heater temperature became 700°C, and from 700°C to 820°C, the furnace was heated at a rate of 5.5°C/hr, and at 820°C, the furnace was held for 180 hours.

Next, the furnace was cooled by a heater program of 1°C/hr down to 700°C, 2°C/hr down to 500°C and 5°C/hr down to 0°C. After the furnace temperature reached room temperature, the test specimen was taken out of the furnace.

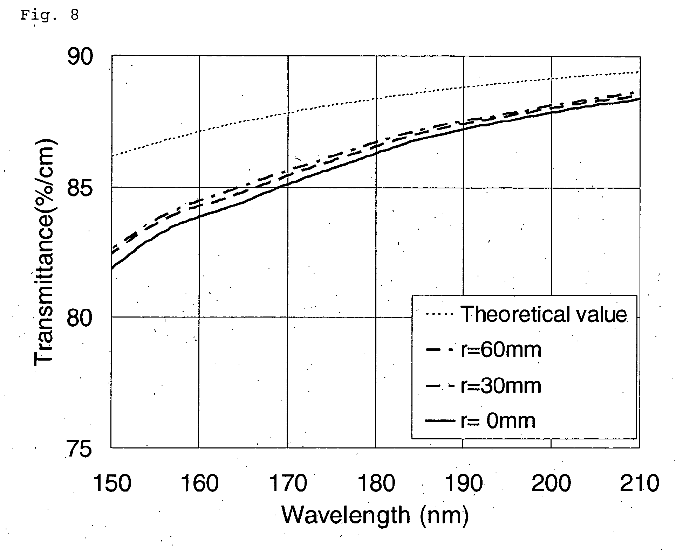

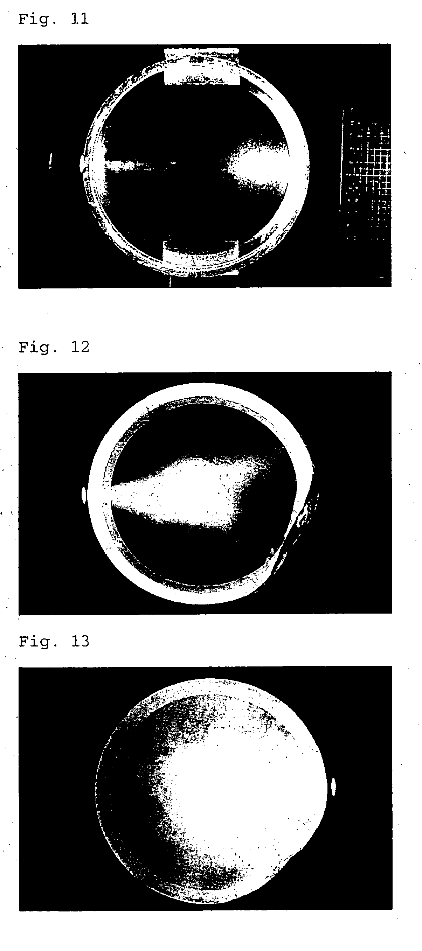

The front and back surfaces of the test specimen were optically polished until the surface roughness (rms) became not more than 3.0 nm, to prepare a sample (thickness: 44 mm) for VUV transmittance measurement, and the sample was measured on the transmittance in the wavelength region of 150 to 210 nm. The results are shown in Fig. 8. The mean value of the VUV transmittances at a wavelength of 193 nm was 87.6%/cm (minimum value: 87.4%/cm, maximum value: 87.7%/cm), and the mean value of the internal transmittances except surface reflection was 98.5%/cm (minimum value: 98.3%/cm, maximum value: 98.7%/cm). The test specimen having been subjected to annealing was irradiated with light of a halogen lamp in a dark room and observed with the naked eye. As a result, it was confirmed that opaqueness present at the central part of the ingot before annealing had disappeared. A photograph taken when the test specimen was observed using light of a halogen lamp is shown in Fig. 11.

### Comparative Example 7

An ingot of a BaLiF₃ single crystal was obtained in the same manner as in Example 11, except that 20900 g of a lump of a BaF₂ raw material and 4100 g of a lump of a LiF raw material were mixed and introduced into a double structure crucible, and the crucible was placed in a CZ furnace. The BaF₂ raw material and the LiF raw material were mixed herein in a Ba/(Ba+Li) mixing ratio by mol of 0.43.

Next, the ingot was cut in the same manner as in Example 11 to obtain a disc, and the disc was measured on the VUV transmittance. As a result, the VUV transmittance at a wavelength of 193 nm was 0%/cm. Then, the disc was irradiated with light of a halogen lamp in a dark room and observed with the naked eye. As a result, it was confirmed that the light was scattered inside the ingot to make the ingot opaque. A photograph taken when the disc was observed using light of a halogen lamp is shown in Fig. 12.

Next, the test specimen was subjected to annealing in the same manner as in Example 11, and then the front and back surfaces of the test specimen were optically polished.

Next, the test specimen having been optically polished was measured on the VUV transmittance, and as a result, the VUV transmittance at a wavelength of 193 nm was 0%/cm. Then, the disc was irradiated with light of a halogen lamp in a dark room and observed with the naked eye. As a result, it was confirmed that opaqueness inside the ingot became more intense than that before annealing. A photograph taken when the disc was observed while irradiating the disc with light of a halogen lamp is shown in Fig. 13.

## Claims

1. A method for producing a BaLiF₃ single crystal by a melt growth method, wherein a raw material melt for said single crystal comprises BaF₂, LiF and MgF₂ in such amounts that the Ba/(Ba+Li+Mg) ratio by mol is in the range of 0.35 to 0.48 and the Mg/(Li+Mg) ratio by mol is in the range of 0.001 to 0.03.

2. A process for producing an optics for vacuum ultraviolet region comprising a BaLiF₃ single crystal, said process comprising a step of producing a BaLiF₃ single crystal by the method of claim 1.

3. A process for producing an optics for vacuum ultraviolet region comprising a BaLiF₃ single crystal, said process comprising a step of producing a BaLiF₃ single crystal by the method of claim 1 and a step of annealing the BaLiF₃ single crystal produced.

4. The process as claimed in claim 2 or 3, wherein the optics for vacuum ultraviolet region is a last lens of immersion exposure tools.

5. A BaLiF₃ single crystal which is a BaLiF₃ single crystal containing Mg in such an amount that the Mg/(Li+Mg)-ratio by mol is in the range of 0.001 to 0.02.

6. The BaLiF₃ single crystal as claimed in claim 5, which is an optics for vacuum ultraviolet region.

7. The BaLiF₃ single crystal as claimed in claim 6, which is a last lens of immersion exposure tools.
